# EUROPÄISCHE PATENTSCHRIFT

(11) **EP 3 479 663 B1**
(45) Veröffentlichungstag und Bekanntmachung des Hinweises auf die Patenterteilung: **20.10.2021**
(21) Anmeldenummer: 17722750.1
(22) Anmeldetag: 09.05.2017
(51) Int. Cl.: H05K 5/00, H01R 12/58, H05K 5/02, H01R 13/52, H01R 43/00, H01R 12/71

(54) **STEUERGERÄTEEINHEIT, INSBESONDERE FÜR EIN KRAFTFAHRZEUG**
CONTROL UNIT, IN PARTICULAR FOR A MOTOR VEHICLE
UNITÉ APPAREIL DE COMMANDE, EN PARTICULIER POUR UN VÉHICULE AUTOMOBILE

(30) Priorität: 30.06.2016 DE 102016211860
(43) Veröffentlichungstag der Anmeldung: 08.05.2019
(73) Patentinhaber: Robert Bosch GmbH, 70442 Stuttgart (DE)
(72) Erfinder: LISKOW, Uwe, 71679 Asperg (DE)
(86) Internationale Anmeldenummer: PCT/EP2017/061051
(87) Internationale Veröffentlichungsnummer: WO 2018/001612

(56) Entgegenhaltungen:
- EP-A1- 1 269 580
- EP-A1- 1 643 820
- DE-A1- 10 014 457
- US-B1- 7 234 950

## Beschreibung

### Gebiet der Erfindung

Die Erfindung betrifft eine Steuergeräteeinheit zum Befestigen von geradlinigen Steckerpins einer Steuergeräteeinheit in einem Leiterplattenelement der Steuergeräteeinheit.

### Stand der Technik

Steuergeräteeinheiten werden oft in einer Ölumgebung betrieben oder es soll gegen z. B. feuchte Umgebungsluft oder Staub geschützt werden, so dass das Leiterplattenelement von einem abdichtenden Gehäuse umgeben sein muss.

Bei bisher bekannte Steuergeräteeinheiten (ECU und TCU, Engine oder Transmission Control Unit) werden sehr lange Steckerpins verwendet, die in das (Kunststoff-)Gehäuse der Steuergeräteeinheit bzw. in das Steckeraufnahmeelement zum Aufnahmen des weiblichen Steckers eingepresst sind bzw. darin befestigt sind. Hierfür werden üblicherweise komplexe und sehr teure Werkzeuge benötigt. Die Toleranzen des Einbaus der Steckerpins sind somit in der Regel von der üblicherweise durch Verschleiß nachlassenden Qualität des Werkzeugs bzw. Spritzwerkzeugs abhängig.

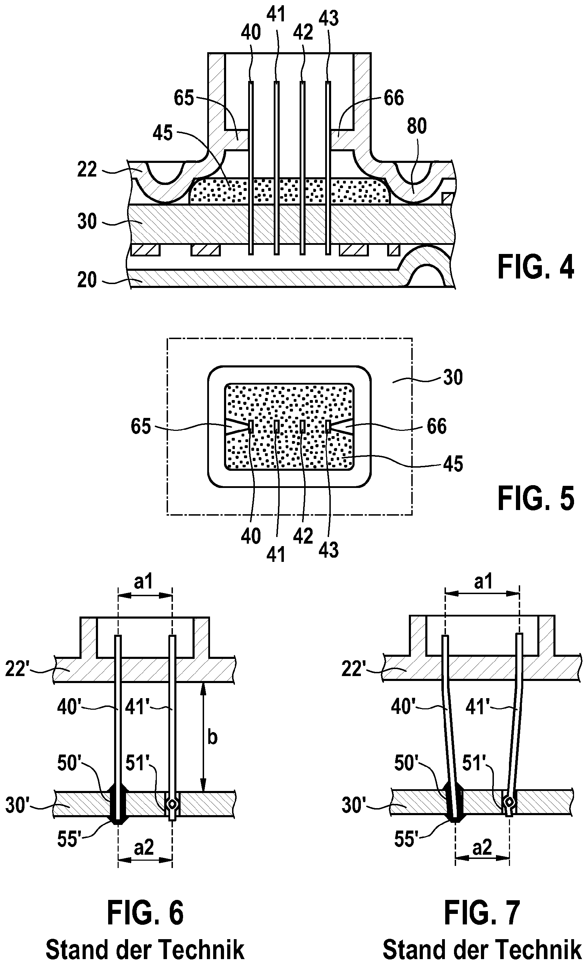

Fig. 6 zeigt eine Teilansicht einer bisher bekannten Steuergeräteeinheit. Zwei geradlinige bzw. gerade Steckerpins 40', 41' zum elektrischen Anschließen von elektrischen Bauelementen auf einem Leiterplattenelement 30' sind in Aufnahmeöffnungen 50', 51' der Leiterplatte befestigt. Zusätzlich sind die beiden Steckerpins 40', 41' in dem Gehäuse 20', genauer gesagt in dem Gehäusedeckel 22', der Teil des Gehäuses 20' ist, bzw. in dem Steckeraufnahmeelement, das Teil des Gehäuses 20' ist, ebenfalls befestigt, z.B. eingepresst. In dem Leiterplattenelement 30' können auch nur eingelötete Steckerpins oder nur eingepresste Steckerpins vorhanden sein. Der in Fig. 6 linke Steckerpin 40' ist mittels Lötmaterial 55' mit dem Leiterplattenelement 30' verlötet. Der rechte Steckerpin 41' in Fig. 6 ist ein Einpresspin und in das Leiterplattenelement 30' eingepresst.

Üblicherweise weisen das Leiterplattenelement 30' und das Gehäuse 20' bzw. der Gehäusedeckel 22' als Teil des Gehäuses 20' bzw. das Steckeraufnahmeelement zueinander unterschiedliche Wärmeausdehnungskoeffizienten auf. Dies führt bei Temperaturänderungen zu Biegebelastungen der Steckerpins 40', 41'. Bei zunehmender Temperatur (Fig. 6 zeigt eine niedrigere Temperatur als Fig. 7) nimmt der Abstand a1 zwischen den Steckerpins 40', 41' am Gehäuse 20' bzw. am Steckeraufnahmeelement stärker zu als der Abstand a2 zwischen den Steckerpins 40', 41' am Leiterplattenelement 30'. Je kleiner der Abstand b, d.h. der Abstand zwischen dem Gehäuse 20' bzw. dem Gehäusedeckel 22' bzw. dem Steckeraufnahmeelement und dem Leiterplattenelement 30', ist, umso größer wird die Biegebelastung der Löt- bzw. Einpressverbindung des Steckerpins 40', 41' in dem Leiterplattenelement 30'. Bei kleinen Abständen b führt dies zu einem Versagen der Verbindung. Daher ist bei bisher bekannten Steuergeräteeinheiten der Abstand b in der Regel recht groß, z.B. im Bereich von ca. 10mm bis ca. 50 mm, um die Biegekräfte bzw. - momente auf die Steckerpins 40', 41' gering zu halten.

Daher weisen bisher bekannte Steuergeräteeinheiten üblicherweise eine große Höhe, d.h. einen großen Abstand zwischen Gehäuse bzw. Gehäusedeckel bzw. Steckeraufnahmeelement und Leiterplattenelement, auf. Dies führt in der Regel zu hohen Materialkosten. Zudem nehmen bisher bekannte Steuergeräteeinheiten üblicherweise ein großes Volumen ein.

Aus der US 7 234 959 B1 ist eine Steuergeräteeinheit bekannt, bei der ein Steckergehäuse mit Hilfe eines thermischen Elastomerharzes in der Öffnung einer Gehäuseeinwand eingemoldet ist.

Die EP 1 269 580 A1 offenbart eine elektronische Baugruppe mit auf einem Schaltungsträger angeordneten Bauelementen und Kontaktierungselementen, bei der in einer Aussparung des Gehäuses ein beweglich gelagertes und sogenannte Pindurchbrüche aufweisendes Einsatzteil vorgesehen ist.

Die DE 100 14 457 A1 offenbart eine Steuergeräteeinheit, bei der eine Leiterplatte mit einer Weichvergussmasse aus Silikon abgedeckt wird. Die Weichvergussmasse ist wiederum mit einer Hartvergussmasse abgedeckt.

### Offenbarung der Erfindung

### Vorteile der Erfindung

Ausführungsformen der vorliegenden Erfindung können in vorteilhafter Weise ermöglichen, eine Steuergeräteeinheit aufzuzeigen, die eine geringe Höhe, d.h. einen geringen Abstand zwischen dem Gehäuse bzw. dem Gehäusedeckel bzw. dem Steckeraufnahmeelement und dem Leiterplattenelement, aufweist und bei der Steckerpins technisch einfach und bei Temperaturänderungen vor Biegekräften geschützt befestigt sind.

Gemäß einem ersten Aspekt der Erfindung wird eine Steuergeräteeinheit, insbesondere für ein Kraftfahrzeug, vorgeschlagen, umfassend: ein Leiterplattenelement mit auf einer Montagefläche des Leiterplattenelements (30) angeordneten elektrischen Bauelementen, ein Gehäuse, in dem das Leiterplattenelement angeordnet ist, und mehrere geradlinige Steckerpins zum Anschließen eines weiblichen Steckers, wobei die Steckerpins jeweils mit einem oder mehreren der elektrischen Bauelemente elektrisch verbunden sind, wobei die Steckerpins in dem Leiterplattenelement befestigt sind und nicht direkt im Gehäuse befestigt sind und das Gehäuse eine Steckeraufnahmeöffnung zum Aufnehmen des weiblichen Steckers aufweist, wobei sich die Steckerpins von dem Leiterplattenelement bis in die Steckeraufnahmeöffnung erstrecken, wobei die Steckeraufnahmeöffnung mindestens eine Zentriernase zum Ausrichten der Steckeraufnahmeöffnung relativ zu den Steckerpins umfasst. Erfindungsgemäß umfasst die Steuergeräteeinheit ferner eine erste Vergussschicht, wobei die erste Vergussschicht zumindest teilweise auf einer ersten Seite des Leiterplattenelements derart aufgebracht ist, dass die erste Vergussschicht jeweils einen Teilbereich der Steckerpins vollständig umschließt.

Ein Vorteil hiervon ist, dass die Steuergeräteeinheit in der Regel sehr flach ausgebildet sein kann, d.h. das Leiterplattenelement nur einen sehr geringen Abstand zu dem Gehäuse bzw. Gehäusedeckel bzw. zu dem Steckeraufnahmeelement zum Aufnehmen des weiblichen Steckers aufweisen kann. Dies führt in der Regel dazu, dass die Steuergeräteeinheit ein besonders kleines Volumen aufweist bzw. einnimmt. Dadurch dass die Steckerpins nicht in zwei Elementen (Leiterplattenelement und Gehäuse bzw. Steckeraufnahmeelement) befestigt sind, sondern nur in einem Element (Leiterplattenelement), können üblicherweise keine Biegekräfte bzw. Biegemoment auf die Steckerpins auftreten. Ein Versagen der Verbindung zwischen Steckerpins und Leiterplattenelement wird hierdurch im Allgemeinen verhindert. Somit sind die Steckerpins typischerweise vor Biegekräften bzw. Biegemomenten geschützt sicher in dem Leiterplattenelement befestigt. Darüber hinaus werden durch die flache Form der Steuergeräteeinheit und die kurze Ausbildung der Steckerpins üblicherweise Materialkosten eingespart.
Unter einem geradlinigen Steckerpin ist ein Steckerpin zu verstehen, der keinen Knick aufweist und eine gerade, d.h. nicht gekrümmte, Form aufweist. Falls der Steckerpin auf der dem Steckeraufnahmebereich bzw. dem Gehäusedeckel abgewandten Seite aus dem Leiterplattenelement hervorsteht, kann dieser Abschnitt bzw. Bereich des Steckerpins gebogen sein bzw. einen Knick aufweisen. Wesentlich ist, dass der Teil des Steckerpins, der von dem Leiterplattenelement in Richtung des Steckeraufnahmeelements hervorsteht, geradlinig ist und keinen Knick aufweist. Ein weiterer Vorteil hiervon ist, dass die Steckerpins in der Regel noch sicherer in dem Leiterplattenelement gehalten werden. Zudem wird hierdurch in der Regel ein Verbiegen der Steckerpins in dem Leiterplattenelement verhindert bzw. die Steckerpins vor einem Verbiegen geschützt. Die erste Vergussschicht kann vor dem Anordnen des Leiterplattenelements in dem Gehäuse oder danach aufgebracht werden.

Ideen zu Ausführungsformen der vorliegenden Erfindung können unter anderem als auf den nachfolgend beschriebenen Gedanken und Erkenntnissen beruhend angesehen werden.

Die Steckerpins können im Wesentlichen senkrecht zu dem Leiterplattenelement angeordnet sein. Hierdurch wird üblicherweise sichergestellt, dass ein Stecker technisch besonders einfach an die Steckerpins angeschlossen werden kann.

Die Steckeraufnahmeöffnung kann zwei Zentriernasen, vorzugsweise vier Zentriernasen, zum Ausrichten der Steckeraufnahmeöffnung relativ zu den Steckerpins umfasst. Vorteilhaft hieran ist, dass die Steckeraufnahmeöffnung und folglich der Stecker, der mit den Steckerpins verbunden wird, typischerweise technisch noch einfacher relativ zu den Steckerpins ausgerichtet ist bzw. werden kann.

Die erste Vergussschicht kann derart auf der ersten Seite des Leiterplattenelements aufgebracht sein und das Gehäuse kann derart ausgebildet sein, dass die erste Vergussschicht einen Bereich zwischen der ersten Seite des Leiterplattenelements und dem Gehäuse öldicht abdichtet. Hierdurch wird üblicherweise das Innere des Gehäuses bzw. das Leiterplattenelement in dem Gehäuse technisch besonders einfach gegen die Umgebung bzw. gegenüber dem Teil des jeweiligen Steckerpins, der mit dem Stecker in Kontakt tritt bzw. treten soll, abgedichtet. Vorteilhaft hieran ist zudem, dass in der Regel Materialkosten eingespart werden, da keine zusätzliche Abdichtungsschicht aufgebracht werden muss. Somit wird ein Eindringen von Öl oder feuchter Luft oder ähnlichem technisch einfach in der Regel verhindert. Die erste Vergussschicht kann durch die Steckeraufnahmeöffnung des Steckeraufnahmeelements eingebracht werden. Das Steckeraufnahmeelement umfasst die Steckeraufnahmeöffnung.

Die der ersten Seite gegenüberliegende zweite Seite des Leiterplattenelements kann zumindest teilweise mit einer zweiten Vergussschicht bedeckt sein, wobei die zweite Vergussschicht insbesondere einen Bereich zwischen der zweiten Seite des Leiterplattenelements und dem Gehäuse abdichtet. Hierdurch werden die Steckerpins in der Regel noch besser in dem Leiterplattenelement gehalten. Zudem wird hierdurch in der Regel technisch einfach eine Abdichtung des Bereichs zwischen der zweiten Seite (Unterseite) des Leiterplattenelements und dem Gehäuse bzw. dem Gehäuseboden erreicht.

Die erste Vergussschicht und/oder die zweite Vergussschicht kann bzw. können ein thixotropes Material umfassen, insbesondere aus einem thixotropen Material bestehen. Hierdurch bleibt in der Regel die erste bzw. die zweite Vergussschicht während des Vernetzens formstabil und verbindet sich mit den Steckerpins und dem Leiterplattenelement (und gegebenenfalls mit dem Gehäuse). Die erste Vergussschicht und/oder zweite Vergussschicht kann eine Höhe von ca. 0,6 mm bis ca. 3,2 mm aufweisen. Insbesondere bei Einpresspins weist thixotropes Material bzw. ein Material mit niedriger Viskosität üblicherweise den Vorteil auf, dass das Material der ersten Vergussschicht und/oder der zweiten Vergussschicht nicht in die Aufnahmeöffnungen der Steckerpins eindringt.

Das Leiterplattenelement kann einen Wärmeausdehnungskoeffizienten aufweisen, der im Bereich von ca. 18 ppm/K liegt. Das Material der ersten und/oder zweiten Vergussschicht kann einen Wärmeausdehnungskoeffizienten in x-/y-Richtung (parallel zur Montagefläche des Leiterplattenelements, auf dem elektrische Bauelemente angeordnet sind) aufweisen, der im Bereich des Wärmeausdehnungskoeffizienten des Leiterplattenelements liegt, d.h. diesem im Wesentlichen entspricht. Der Wärmeausdehnungskoeffizienten der jeweiligen Vergussschicht kann durch Füllstoffe entsprechend angepasst werden.

Das Leiterplattenelement kann Aufnahmeöffnungen zum Aufnehmen der Steckerpins umfassen. Ein Vorteil hiervon ist, dass in der Regel die Herstellungskosten der Steuergeräteeinheit sinken.

Die erste Vergussschicht und/oder die zweite Vergussschicht kann bzw. können den im Wesentlichen gleichen Wärmeausdehnungskoeffizienten wie das Leiterplattenelement aufweisen. Ein Vorteil hiervon ist, dass in der Regel das Auftreten bzw. Entstehen von Biegemomenten noch stärker verhindert wird. Hierdurch wird eine besonders sichere Verbindung zwischen Steckerpins und Leiterplattenelement in der Regel erreicht.

Die Steuergeräteeinheit kann in der Regel sehr flach ausgebildet werden, d.h. das Leiterplattenelement kann nur einen sehr geringen Abstand zu dem Gehäuse bzw. Gehäusedeckel bzw. zu dem Steckeraufnahmeelement zum Aufnehmen des weiblichen Steckers aufweisen kann. Dies führt in der Regel dazu, dass die derart hergestellte Steuergeräteeinheit ein besonders kleines Volumen aufweist bzw. einnimmt. Dadurch dass die Steckerpins nicht in zwei Elementen (Leiterplattenelement und Gehäuse bzw. Steckeraufnahmeelement) befestigt sind, sondern nur in einem Element (Leiterplattenelement), können üblicherweise keine Biegekräfte bzw. Biegemoment auf die Steckerpins auftreten. Ein Versagen der Verbindung zwischen Steckerpins und Leiterplattenelement wird hierdurch im Allgemeinen verhindert. Somit sind die Steckerpins typischerweise vor Biegekräften bzw. Biegemomenten geschützt sicher in dem Leiterplattenelement befestigt. Darüber hinaus werden durch die flache Form der Steuergeräteeinheit und die kurze Ausbildung der Steckerpins üblicherweise Materialkosten eingespart, wodurch das Verfahren in der Regel sehr kostengünstig ist. Das von dem Leiterplattenelemente abgewandte Ende des jeweiligen Steckerpins kann frei beweglich sein bzw. verbleiben.

Es wird darauf hingewiesen, dass einige der möglichen Merkmale und Vorteile der Vorrichtung hierin mit Bezug auf unterschiedliche Ausführungsformen beschrieben sind. Ein Fachmann erkennt, dass die Merkmale in geeigneter Weise kombiniert, angepasst oder ausgetauscht werden können, um zu weiteren Ausführungsformen der Erfindung zu gelangen.

### Kurze Beschreibung der Zeichnungen

Nachfolgend werden Ausführungsformen der Erfindung unter Bezugnahme auf die beigefügten Zeichnungen beschrieben, wobei weder die Zeichnungen noch die Beschreibung als die Erfindung einschränkend auszulegen sind.
- Fig. 1 zeigt: eine schematische Querschnittsansicht einer ersten Ausführungsform der erfindungsgemäßen Steuergeräteeinheit;
- Fig. 2 zeigt: eine Detailansicht der Steuergeräteeinheit aus Fig. 1;
- Fig. 3 zeigt: eine Detailansicht einer zweiten Ausführungsform der erfindungsgemäßen Steuergeräteeinheit;
- Fig. 4 zeigt: eine Detailansicht einer dritten Ausführungsform der erfindungsgemäßen Steuergeräteeinheit;
- Fig. 5 zeigt: eine Aufsicht auf die Steuergeräteeinheit aus Fig. 4;
- Fig. 6 zeigt: eine Detailansicht einer Steuergeräteeinheit gemäß des Stands der Technik bei einer ersten Temperatur; und
- Fig. 7 zeigt: die Steuergeräteeinheit aus Fig. 6 bei einer zweiten Temperatur, die höher als die erste Temperatur ist.

Die Figuren sind lediglich schematisch und nicht maßstabsgetreu. Gleiche Bezugszeichen bezeichnen in den Figuren gleiche oder gleichwirkende Merkmale.

### Ausführungsformen der Erfindung

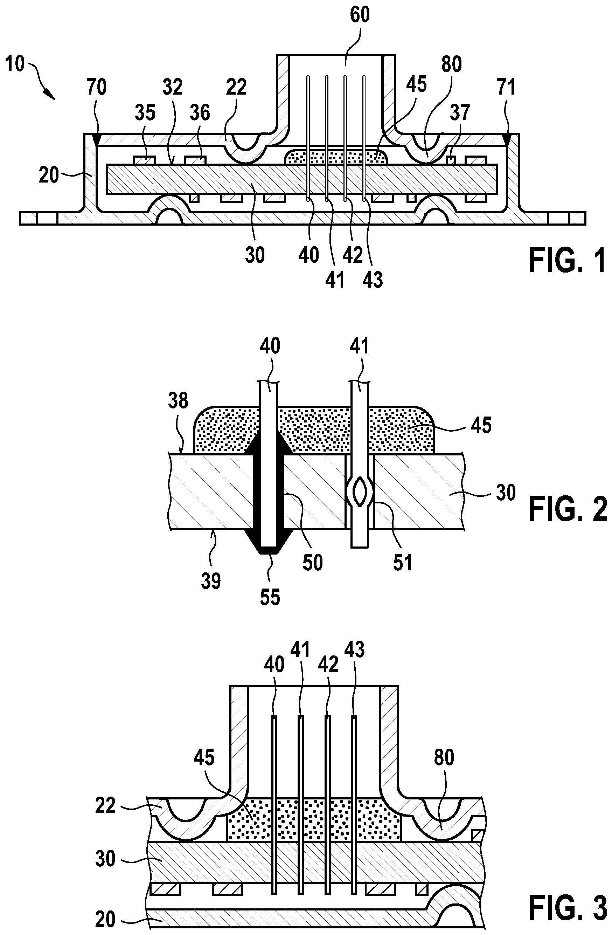

Fig. 1 zeigt eine schematische Querschnittsansicht einer ersten Ausführungsform der erfindungsgemäßen Steuergeräteeinheit 10. Fig. 2 zeigt eine Detailansicht der Steuergeräteeinheit 10 aus Fig. 1. Die Steuergeräteeinheit 10 umfasst ein Gehäuse 20 und ein Leiterplattenelement 30, wobei das Leiterplattenelement 30 in dem Gehäuse 20 angeordnet ist. Das Gehäuse 20 umfasst einen Gehäuseboden und einen Gehäusedeckel 22. Das Gehäuse 20 umschließt das Leiterplattenelement 30 und schützt das Leiterplattenelement 30 und die elektrischen Bauelemente 35, 36, 37 auf dem Leiterplattenelement durch das Abdichtelement 80 vor dem umgebenden Medium (Luft, Öl usw.). Das Abdichtelement 80 ist eine von dem Gehäusedeckel 22 zu dem Leiterplattenelement 30 hin vorstehender Vorsprung, der einen Teilbereich der Steckerpins 40-43 kreisförmig auf der Montagefläche 32 umschließt. Das Abdichtelement 80 liegt an der Montagefläche 32 des Leiterplattenelements 30 an. Der Gehäusedeckel 22 ist über einen bzw. zwei Abdichtungsvergüsse 70, 71 abdichtend mit dem restlichen Teil des Gehäusedeckels 22 verbunden.

Das Abdichtelement 80 kann auch Niederhaltefunktion haben und die Leiterplatte fixieren, d.h. an einer vorgegebenen Position festhalten.

Auf einer Montagefläche 32 des Leiterplattenelements 30, der ersten Seite 38 des Leiterplattenelements 30, und der der Montagefläche 32 abgewandten zweite Seite 39 des Leiterplattenelements 30 sind elektrische Bauelemente 35, 36, 37 angeordnet. Die Steuergeräteeinheit 10 dient beispielsweise zum Steuern bzw. Regeln eines Getriebes in einem Fahrzeug. Die Steuergeräteeinheit 10 kann in einem Fahrzeug angeordnet sein. Das Leiterplattenelement 30 kann ein Printed Circuit Board (PCB) sein.

Der Gehäusedeckel 22 bzw. das Gehäuse 20 weist ein Steckeraufnahmeelement, das integral mit dem Gehäusedeckel 22 ausgebildet ist, und in dem Steckeraufnahmeelement eine Steckeraufnahmeöffnung 60 zur Aufnahme eines weiblichen Steckers auf. Die Steckeraufnahmeöffnung 60 ist (in Fig. 1) nach oben hin offen, damit der Stecker in die Steckeraufnahmeöffnung 60 eingeführt und mit den Steckerpins 40-43 (elektrisch) verbunden werden kann. Der weibliche Stecker wird mit Steckerpins 40-43 verbunden. Die Steckerpins 40-43 (deren Anzahl z.B. ca. 50 oder ca. 200 betragen kann) sind jeweils mit einem oder mehreren der elektrischen Bauelemente 35, 36, 37 verbunden.

Die Steckerpins 40-43 sind jeweils in einer Aufnahmeöffnung 50, 51 des Leiterplattenelements 30 angeordnet und hierdurch mit dem Leiterplattenelement 30 verbunden. Die Steckerpins 40-43 können z.B. Lötpins, die über ein Lötmaterial 55 mit dem Leiterplattenelement 30 verlötet sind, oder Einpresspins sein. In dem Leiterplattenelement 30 können Steckerpins vorhanden sein, die eingepresst oder eingelötet sind. Vorstellbar ist auch, dass das Leiterplattenelement 30 sowohl gelötete als auch eingepresste Steckerpins 40-43 aufweist. Die Steckerpins 40-43 können über die untere zweite Seite 39 des Leiterplattenelements 30 (in Fig. 1 bzw. in Fig. 2 unten) hinausstehen.

Die Steckerpins 40-43 sind geradlinig bzw. gerade ausgebildet. Die Steckerpins 40-43 sind nicht direkt bzw. nicht unmittelbar mit dem Gehäuse 20 bzw. dem Gehäusedeckel 22 bzw. dem Steckeraufnahmeelement verbunden bzw. nicht direkt bzw. nicht unmittelbar an/im dem Gehäuse 20 bzw. Gehäusedeckel 22 bzw. Steckeraufnahmeelement befestigt. Unter einer direkten Befestigung der Steckerpins 40-43 im Gehäuse ist auch eine Befestigung der Steckerpins 40-43 mittels Klebers oder sonstiger Verbindungsmittel (Lötmaterial etc.) im Gehäuse 20 zu verstehen. Insbesondere weist das Gehäuse 20 bzw. der Gehäusedeckel 22 des Gehäuses 20 bzw. das Steckeraufnahmeelement keine Aufnahmeöffnungen auf, in denen die Steckerpins 40-43 angeordnet oder befestigt sind. Die Steckerpins 40-43 können ausschließlich in dem Leiterplattenelement 30 befestigt sein. Die Steckerpins 40-43 sind in dem Leiterplattenelement 30 befestigt, welches ortsfest in dem Gehäuse 20 angeordnet ist bzw. an dem Gehäuse befestigt sein kann.

Die Steckerpins 40-43 werden im Gehäuse 20 nicht einzeln geführt. In dem Gehäuse 20 befinden sich somit nicht Öffnungen für jeweils einen einzelnen Steckerpin 40-43, sondern mehrere Steckerpins 40-43 gemeinsam befinden sich in einer Steckeraufnahmeöffnung 60 bzw. erstrecken sich in diese hinein.

Die Steckerpins 40-43 erstrecken sich von den Aufnahmeöffnungen 50, 51 des Leiterplattenelements 30 bis in die Steckeraufnahmeöffnung 60 hinein. Die Aufnahmeöffnungen 50, 51 können sich über die gesamte Höhe (in Fig. 1 bzw. in Fig. 2 von oben nach unten verlaufend) oder über einen Teil der Höhe des Leiterplattenelements 30 erstrecken.

Auf der ersten Seite 38 des Leiterplattenelements 30, auf der auch die Montagefläche 32 angeordnet ist, ist eine erste Vergussschicht 45 um die Steckerpins 40-43 herum aufgebracht bzw. angeordnet. Diese erste Vergussschicht 45 kann beim Herstellen des Leiterplattenelements 30 (nach dem Befestigen der Steckerpins 40-43 in dem Leiterplattenelement 30) aufgebracht und ausgehärtet worden sein. Vorstellbar ist auch, dass die erste Vergussschicht 45 durch die Steckeraufnahmeöffnung 60 eingebracht und dann ausgehärtet wird, d.h. nachdem das Leiterplattenelement 30 in dem Gehäuse 20 bzw. zwischen Boden und Gehäusedeckel 22 des Gehäuses 20 angeordnet wurde. Auf der zweiten Seite 39, d.h. der in Fig. 1 unteren Seite des Leiterplattenelements 30, kann eine zweite Vergussschicht (nicht gezeigt) um die Steckerpins 40-43 angeordnet sein. Die erste Vergussschicht 45 und/oder die zweite Vergussschicht überdeckt somit die Verbindung zwischen dem jeweiligen Steckerpin 40-43 und dem Leiterplattenelement 30. Die Vergussschicht 45 umschließt einen Teilbereich der Steckerpins 40-43 vollständig. Die Steckeraufnahmeöffnung 60 wird durch Verbindung des Steckers mit den Steckerpins 40-43 öldicht (oder luftfeuchtedicht oder in Summe "abdichtend") abgedichtet.

Fig. 3 zeigt eine Detailansicht einer zweiten Ausführungsform der erfindungsgemäßen Steuergeräteeinheit 10. Die in Fig. 3 gezeigt Ausführungsform unterscheidet sich von der in Fig. 1 bzw. in Fig. 2 gezeigten Ausführungsform darin, dass die erste Vergussschicht 45 das Innere bzw. das Innenvolumen, das von dem Gehäuse 20 bzw. von Gehäuseboden und Gehäusedeckel 22 umschlossen wird, gegenüber der Steckeraufnahmeöffnung 60 abdichtet. Das Leiterplattenelement 30 ist somit gegenüber der Steckeraufnahmeöffnung 60, die nach oben hin (ohne verbundenen Stecker) offen ist, öldicht (oder luftfeuchtedicht oder in Summe "abdichtend") abgedichtet. Wenn der Stecker in die Steckeraufnahmeöffnung 60 eingeführt und mit den Steckerpins 40-43 verbunden ist, dichtet der Stecker die Steckeraufnahmeöffnung 60 nach oben hin dicht ab.

Fig. 4 zeigt eine Detailansicht einer dritten Ausführungsform der erfindungsgemäßen Steuergeräteeinheit 10. Fig. 5 zeigt eine Aufsicht auf die Steuergeräteeinheit 10 aus Fig. 4.

Die in Fig. 4 bzw. in Fig. 5 gezeigte Ausführungsform unterscheidet sich von den Ausführungsformen, die in den Fig. 1-3 gezeigt ist, darin, dass die Steckeraufnahmeöffnung 60 zwei Zentriernasen 65, 66 bzw. Führungsnasen aufweist. Die zwei Zentriernasen 65, 66 sind Vorsprünge, die von der Innenwandoberfläche der Steckeraufnahmeöffnung 60 nach innen, d.h. zu den Steckerpins 40-43 und somit einander zugewandt, vorstehen. Die beiden Zentriernasen 65, 66 sind in der Aufsicht gemäß Fig. 5 mittig und symmetrisch angeordnet.

Die Zentriernasen 65, 66 dienen zum Ausrichten bzw. Positionieren des Deckels bzw. des Gehäusedeckels 22, der nach dem Anordnen des Leiterplattenelements 30 in dem Boden des Gehäuses 20 auf den Boden des Gehäuses 20 gesetzt wird, relativ zu den Steckerpins 40-43. Hierdurch werden die Steckerpins 40-43 zentral/mittig und symmetrisch in der Steckeraufnahmeöffnung 60 ausgerichtet. Dies erleichtert den Anschluss des Steckers bzw. die Verbindung des weiblichen Steckers mit den Steckerpins 40-43. Es können auch zusätzlich oder alternativ Zentriernasen zum Ausrichten in der y-Richtung (diese verläuft in Fig. 5 von oben nach unten) vorhanden sein. Die Zentriernasen 65, 66 sorgen dafür, dass die Steckerpins 40-43 zentriert in der Steckeraufnahmeöffnung 60 angeordnet sind.

Die erste Vergussschicht 45 und/oder die zweite Vergussschicht kann ein ein- oder zweikomponentige, thermisch härtende Polymersysteme (1K, 2K), z.B. vorwiegend auf Epoxidharzen, Polyurethanen, Silikon und/oder Acrylat basierend, umfassen. Die Härtung bzw. Aushärtung der flüssig bzw. zähflüssig aufgebrachten ersten Vergussschicht 45 und/oder zweiten Vergussschicht kann durch UV-Strahlung erreicht werden, insbesondere wenn das UV-Licht große Flächen bzw. Volumen der jeweiligen Vergussschicht 45 erreicht. Auch möglich sind Hybridwerkstoffe, die durch partielle UV-Bestrahlung mit der Vernetzung beginnen und dann ohne weitere UV-Bestrahlung auch in Bereichen vernetzen bzw. hineinnetzen, die im Schatten lagen, d.h. nicht (direkt) von der UV-Bestrahlung betroffen waren.

Das Material der ersten Vergussschicht 45 und/oder der zweiten Vergussschicht kann Epoxidharz umfassen. Epoxidharz erfüllt die Anforderungen an Temperaturbeständigkeit und Medienbeständigkeit. Zudem lässt sich Epoxidharz auf einen Wärmeausdehnungskoeffizienten einstellen, der dem Wärmeausdehnungskoeffizienten des Leiterplattenelements 30 bzw. des Printed Circuit Boards entspricht bzw. gleich diesem Wert ist. Die erste Vergussschicht 45 und/oder die zweite Vergussschicht kann durch Wärme oder Energiestrahlung ausgehärtet werden, z.B. in einem Aushärteofen, unter einer Wärmelampe und/oder mit UV-Licht, abhängig von dem Härtesystem des Materials der ersten Vergussschicht 45 und/oder der zweiten Vergussschicht.

Die jeweilige Vergussschicht 45 hält nach dem Aushärten die Steckerpins 40-43 (zusätzlich) fest und schützt diese gegen eine Verbiegung des in Fig. 1 bzw. in Fig. 2 unteren Teils der Steckerpins 40-43.

Der Gehäusedeckel 22 des Gehäuses 20 umfasst Kunststoff, Metall oder Kunststoff mit Metalleinlagen oder besteht aus diesem Material. Metall im Boden des Gehäuses 20 oder im Gehäusedeckel 22 des Gehäuses 20 dient als EMV-Schutz (Elektromagnetische Verträglichkeit). Hierdurch wird Störeinstrahlung vermieden und das Abstrahlen von elektromagnetischen Wellen der Steuergeräteeinheit 10 nach außen wird vermindert. Zudem kann das Metall als Wärmesenke und/oder zur mechanischen Befestigung der Steuergeräteeinheit 10 im Fahrzeug dienen.

Die Steuergeräteeinheit 10 kann zum Steuern bzw. Regeln eines Getriebes, eines Motors und/oder einer Lenkung dienen.

Abschließend ist darauf hinzuweisen, dass Begriffe wie "aufweisend", "umfassend", etc. keine anderen Elemente oder Schritte ausschließen und Begriffe wie "eine" oder "ein" keine Vielzahl ausschließen. Bezugszeichen in den Ansprüchen sind nicht als Einschränkung anzusehen.

## Patentansprüche

1. Steuergeräteeinheit (10), insbesondere für ein Kraftfahrzeug, umfassend:
ein Leiterplattenelement (30) mit auf einer Montagefläche (32) des Leiterplattenelements (30) angeordneten elektrischen Bauelementen (35, 36, 37),
ein Gehäuse (20), in dem das Leiterplattenelement (30) angeordnet ist, und mehrere geradlinige Steckerpins (40-43) zum Anschließen eines weiblichen Steckers, wobei die Steckerpins (40-43) jeweils mit einem oder mehreren der elektrischen Bauelemente (35, 36, 37) elektrisch verbunden sind,
wobei
die Steckerpins (40-43) in dem Leiterplattenelement (30) befestigt sind und nicht direkt im Gehäuse (20) befestigt sind und das Gehäuse (20) eine Steckeraufnahmeöffnung (60) zum Aufnehmen des weiblichen Steckers aufweist,
wobei sich die Steckerpins (40-43) von dem Leiterplattenelement (30) bis in die Steckeraufnahmeöffnung (60) erstrecken,
wobei die Steckeraufnahmeöffnung (60) mindestens eine Zentriernase (65, 66) zum Ausrichten der Steckeraufnahmeöffnung (60) relativ zu den Steckerpins (40-43) umfasst, **dadurch gekennzeichnet, dass** die Steuergeräteeinheit ferner eine erste Vergussschicht (45) umfasst, wobei die erste Vergussschicht (45) zumindest teilweise auf einer ersten Seite (38) des Leiterplattenelements (30) derart aufgebracht ist, dass die erste Vergussschicht (45) jeweils einen Teilbereich der Steckerpins (40-43) vollständig umschließt.

2. Steuergeräteeinheit (10) nach Anspruch 1 oder 2, wobei die Steckerpins (40-43) im Wesentlichen senkrecht zu dem Leiterplattenelement (30) angeordnet sind.

3. Steuergeräteeinheit (10) nach einem der vorhergehenden Ansprüche, wobei die Steckeraufnahmeöffnung (60) zwei Zentriernasen (65, 66) und vorzugsweise vier Zentriernasen zum Ausrichten der Steckeraufnahmeöffnung (60) relativ zu den Steckerpins (40-43) umfasst.

4. Steuergeräteeinheit (10) nach einem der vorhergehenden Ansprüche, wobei die erste Vergussschicht (45) derart auf der ersten Seite (38) des Leiterplattenelements (30) aufgebracht ist und das Gehäuse (20) derart ausgebildet ist, dass die erste Vergussschicht (45) einen Bereich zwischen der ersten Seite (38) des Leiterplattenelements (30) und dem Gehäuse (20) öldicht abdichtet.

5. Steuergeräteeinheit (10) nach einem der vorhergehenden Ansprüche, wobei die der ersten Seite (38) gegenüberliegende zweite Seite (39) des Leiterplattenelements (30) zumindest teilweise mit einer zweiten Vergussschicht bedeckt, wobei die zweite Vergussschicht insbesondere einen Bereich zwischen der zweiten Seite (39) des Leiterplattenelements (30) und dem Gehäuse (20) abdichtet.

6. Steuergeräteeinheit (10) nach einem der vorhergehenden Ansprüche, wobei die erste Vergussschicht (45) und/oder die zweite Vergussschicht ein thixotropes Material umfasst, insbesondere aus einem thixotropen Material besteht.

7. Steuergeräteeinheit (10) nach einem der vorhergehenden Ansprüche, wobei das Leiterplattenelement (30) Aufnahmeöffnungen (50, 51) zum Aufnehmen der Steckerpins (40-43) umfasst.

8. Steuergeräteeinheit (10) nach einem der vorhergehenden Ansprüche, wobei die erste Vergussschicht (45) und/oder die zweite Vergussschicht den im Wesentlichen gleichen Wärmeausdehnungskoeffizienten wie das Leiterplattenelement (30) aufweist.

## Claims

1. Control device unit (10), in particular for a motor vehicle, comprising:
a circuit board element (30) having electrical components (35, 36, 37) arranged on a mounting surface (32) of the circuit board element (30),
a housing (20) in which the circuit board element (30) is arranged, and
a plurality of rectilinear connector pins (40-43) for connecting a female connector, wherein the connector pins (40-43) are each electrically connected to one or more of the electrical components (35, 36, 37),
wherein
the connector pins (40-43) are fastened in the circuit board element (30) and are not fastened directly in the housing (20), and the housing (20) has a connector reception opening (60) for receiving the female connector,
wherein the connector pins (40-43) extend from the circuit board element (30) into the connector reception opening (60),
wherein the connector reception opening (60) comprises at least one centring lug (65, 66) for aligning the connector reception opening (60) relative to the connector pins (40-43), **characterized in that** the control device unit further comprises a first casting layer (45), wherein the first casting layer (45) is at least partially applied to a first side (38) of the circuit board element (30) in such a way that the first casting layer (45) in each case completely surrounds a partial area of the connector pins (40-43).

2. Control device unit (10) according to Claim 1 or 2, wherein the connector pins (40-43) are arranged substantially perpendicularly to the circuit board element (30).

3. Control device unit (10) according to either of the preceding claims, wherein the connector reception opening (60) comprises two centring lugs (65, 66), and preferably four centring lugs, for aligning the connector reception opening (60) relative to the connector pins (40-43).

4. Control device unit (10) according to one of the preceding claims, wherein the first casting layer (45) is applied to the first side (38) of the circuit board element (30) in such a way, and the housing (20) is designed in such a way, that the first casting layer (45) seals off an area between the first side (38) of the circuit board element (30) and the housing (20) in an oil-tight manner.

5. Control device unit (10) according to one of the preceding claims, wherein the second side (39), opposite the first side (38), of the circuit board element (30) is at least partially covered by a second casting layer, wherein the second casting layer in particular seals off an area between the second side (39) of the circuit board element (30) and the housing (20).

6. Control device unit (10) according to one of the preceding claims, wherein the first casting layer (45) and/or the second casting layer comprise/comprises a thixotropic material, in particular consist/consists of a thixotropic material.

7. Control device unit (10) according to one of the preceding claims, wherein the circuit board element (30) comprises reception openings (50, 51) for receiving the connector pins (40-43).

8. Control device unit (10) according to one of the preceding claims, wherein the first casting layer (45) and/or the second casting layer have/has substantially the same coefficient of thermal expansion as the circuit board element (30).

## Revendications

1. Unité de commande (10), destinée notamment à un véhicule automobile, ladite unité comprenant :
un élément de carte de circuit imprimé (30) pourvu de composants électriques (35, 36) disposés sur une surface de montage (32) de l'élément de carte de circuit imprimé (30), 37),
un boîtier (20) dans lequel l'élément de carte de circuit imprimé (30) est disposé, et une pluralité de broches de connecteur droites (40-43) destinées au raccordement d'un connecteur femelle, les broches de connecteur (40-43) étant chacune reliées électriquement à un ou plusieurs des composants électriques (35, 36, 37),
les broches de connecteur (40-43) étant fixées dans l'élément de carte de circuit imprimé (30) et n'étant pas fixées directement dans le boîtier (20) et le boîtier (20) comportant une ouverture de réception de connecteur (60) destinée à recevoir le connecteur femelle,
les broches de connecteur (40-43) s'étendant de l'élément de carte de circuit imprimé (30) jusque dans l'ouverture de réception de connecteur (60), l'ouverture de réception de connecteur (60) comprenant au moins un ergot de centrage (65, 66) destiné à orienter l'ouverture de réception de connecteur (60) par rapport aux broches de connecteur (40-43), **caractérisé en ce que** l'unité de commande comprend en outre un premier couche d'enrobage (45), la première couche d'enrobage (45) étant au moins partiellement appliquée sur un premier côté (38) de l'élément de carte de circuit imprimé (30) de manière à ce que la première couche d'enrobage (45) enferme complètement une zone des broches de connecteur (40 -43).

2. Unité de commande (10) selon la revendication 1 ou 2, les broches de connecteur (40-43) étant disposées sensiblement perpendiculairement à l'élément de carte de circuit imprimé (30).

3. Unité de commande (10) selon l'une des revendications précédentes, l'ouverture de réception de connecteur (60) comprenant deux ergots de centrage (65, 66) et de préférence quatre ergots de centrage destinés à orienter l'ouverture de réception de connecteur (60) par rapport aux broches de connecteur (40-43).

4. Unité de commande (10) selon l'une des revendications précédentes, la première couche d'enrobage (45) étant appliquée sur le premier côté (38) de l'élément de carte de circuit imprimé (30) et le boîtier (20) étant conçu de manière à ce que la première couche d'enrobage (45) rende étanche à l'huile une zone située entre le premier côté (38) de l'élément de carte de circuit imprimé (30) et le boîtier (20).

5. Unité de commande (10) selon l'une des revendications précédentes, le deuxième côté (39) de l'élément de carte de circuit imprimé (30) qui est opposé au premier côté (38) étant au moins partiellement recouvert d'une deuxième couche d'enrobage, la deuxième couche d'enrobage rendant étanche en particulier une zone située entre le deuxième côté (39) de l'élément de carte de circuit imprimé (30) et le boîtier (20).

6. Unité de commande (10) selon l'une des revendications précédentes, la première couche d'enrobage (45) et/ou la deuxième couche d'enrobage comprenant un matériau thixotrope, en particulier étant en un matériau thixotrope.

7. Unité de commande (10) selon l'une des revendications précédentes, l'élément de carte de circuit imprimé (30) comprenant des ouvertures de réception (50, 51) destinées à recevoir les broches de connecteur (40-43).

8. Unité de commande (10) selon l'une des revendications précédentes, la première couche d'enrobage (45) et/ou la deuxième couche d'enrobage ayant des coefficients de dilatation thermique sensiblement identiques à celui de l'élément de carte de circuit imprimé (30).
